# EUROPÄISCHE PATENTSCHRIFT

(11) **EP 0 783 107 B1**
(45) Veröffentlichungstag und Bekanntmachung des Hinweises auf die Patenterteilung: **18.07.2001**
(21) Anmeldenummer: 96120428.6
(22) Anmeldetag: 18.12.1996
(51) Int. Cl.: G01P 15/08

(54) **Herstellverfahren für ein mikromechanisches Bauteil mit einer beweglichen Struktur**
Manufacturing process for a micromechanical element with movable structure
Procédé de fabrication pour un élément micro-mécanique avec une structure mobile

(30) Priorität: 08.01.1996 DE 19600399
(43) Veröffentlichungstag der Anmeldung: 09.07.1997
(73) Patentinhaber: Infineon Technologies AG, 81669 München (DE)
(72) Erfinder: Werner, Wolfgang, Dr.-Ing., 81545 München (DE)
(74) Vertreter: Zedlitz, Peter, Dipl.-Inf.

(56) Entgegenhaltungen:
- EP-A- 0 680 064
- EP-A- 0 766 090
- WO-A-93/21536
- WO-A-96/01483

## Beschreibung

Die Erfindung betrifft ein Herstellverfahren für ein mikromechanisches Bauteil mit einer beweglichen mikromechanischen Struktur.

Mikromechanisches Bauteile mit einer beweglichen Struktur besitzen ein weites Anwendungsgebiet, beispielsweise als Motoren oder Kraftsensoren (Beschleunigungs- oder Neigungssensoren). Dabei besteht ein großes Interesse an Herstellverfahren, die mit der Fertigung von integrierten Schaltungen, insbesondere auf einem Silizium-Substrat kompatibel sind. Nur eine Kompatibilität der Herstellungsprozesse erlaubt die Integration von Mikromechanik und Ansteuer- und Auswerteschaltungen in Mikrosystemen. Dies ist auch dann wichtig, wenn bestehende Halbleiterfertigungsanlagen auch zur Herstellung von mikromechanischen Strukturen genutzt werden sollen.

Bei den üblichen Herstellverfahren wird die bewegliche Struktur durch eine isotrope, meist naßchemische, Entfernung einer sie umgebenden Schicht freigelegt. Dabei besteht das Problem, daß ein Verkleben der beweglichen Teile mit ihrer Unterlage (sogenanntes Sticking) auftritt. Dieser Effekt wird verursacht durch Adhäsionskräfte, die bei Strukturen mit geringen Abständen, typischerweise < 1 *µ*m, sehr groß sind.

Eine bekannte Lösung dieses Problems sieht vor, nach dem Freiätzen der beweglichen Teile das Ätzmittel oder ein nachfolgend verwendetes Spülmittel (z. B. Wasser) durch eine sublimierende Chemikalie zu ersetzen. Das Bauteil wird dann abgekühlt, so daß die bewegliche Struktur von einer dünnen Schicht dieser Chemikalie umgeben ist, welche anschließend sublimiert. Geeignete Chemikalien sind z. B. Cyklohexan oder Dichlorbenzol. Da die benötigten Chemikalien nicht in der notwendigen Reinheit zur Verfügung stehen, ist dieses Verfahren nicht kompatibel mit der Fertigung von integrierten Schaltkreisen. Insbesondere ist es nicht für die Herstellung von Mikrosystemen einsetzbar.

Der Erfindung liegt daher die Aufgabe zugrunde, ein verbessertes Herstellverfahren für ein mikromechanisches Bauteil mit einer beweglichen Struktur anzugeben, bei dem der Sticking-Effekt vermieden wird.

Diese Aufgabe wird durch ein Verfahren mit den Merkmalen des Patentanspruchs 1 gelöst.

Die Erfindung beruht auf dem Einsatz einer Hilfsstruktur, mit welcher die bewegliche Struktur vor ihrem Freiätzen an einer als Halterung dienenden Schicht befestigt wird. Die bewegliche Struktur wird dann freigelegt, indem eine sie umgebende Zwischenschicht isotrop naßchemisch entfernt wird. Dabei bleibt die bewegliche Struktur aber über die Hilfsstruktur mit der Halterung verbunden. Die beim Trocknen auftretenden Adhäsionskräfte können daher nicht zu einem Verkleben der beweglichen Struktur mit beispielsweise dem Untergrund führen. Erst danach wird die Hilfsstruktur entfernt, so daß die bewegliche Struktur vollständig beweglich wird.

Als Halterung kann beispielsweise das Substrat selber oder eine feste Struktur des mikromechanischen Bauteils dienen. Sie kann unter- oder oberhalb der beweglichen Struktur oder auf gleicher Höhe mit ihr liegen. Beim Entfernen der Zwischenschicht muß sie mit dem Substrat und über die Hilfsstruktur mit der beweglichen Struktur verbunden bleiben.

Die Hilfsstruktur besteht aus einem Material, welches beim Entfernen der Zwischenschicht nicht angegriffen wird und welches am Ende des Verfahrens einfach entfernt werden kann. Geeignet ist hierfür beispielsweise Fotolack.

Um die Hilfsstruktur wie gefordert herzustellen, wird eine Öffnung in der Zwischenschicht derart erzeugt, daß die Oberflächen der beweglichen Struktur und der Halterung teilweise freiliegen. Dann wird eine fotoempfindliche Schicht (Fotolack) aufgebracht, wodurch in der Öffnung die Hilfsstruktur erzeugt wird, so daß sie die bewegliche Struktur und die Halterung verbindet. Aus der fotoempfindlichen Schicht wird mithife einer Belichtung und Entwicklung eine Maske hergestellt, deren Maskenöffnungen das Freilegen der beweglichen Struktur ermöglichen. Durch die Maskenöffnungen hindurch wird also die Zwischenschicht geätzt.

Bei dem Verfahren werden ausschließlich Prozesse eingesetzt, die auch bei der Herstellung von integrierten Schaltungen benutzt werden, so daß die geforderte Kompatibilität vorliegt.

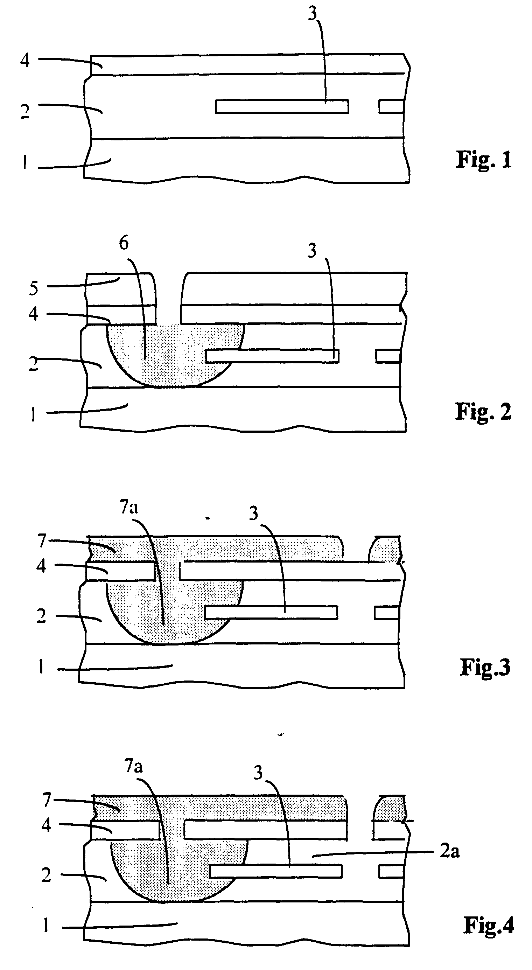

Die Erfindung wird im folgenden anhand eines in den Figuren dargestellten Ausführungsbeispiels näher erläutert. Die Figuren 1 bis 4 zeigen einen Querschnitt durch ein Halbleitersubstrat mit einem mikromechanischen Bauteil, an dem die Verfahrensschritte verdeutlicht werden.
- FIG 1: Ausgangspunkt für das Herstellverfahren ist ein Silizium-Substrat 1, auf welches eine Zwischenschicht 2 und eine bewegliche Struktur 3 aufgebracht sind. Die Zwischenschicht 2 besteht beispielsweise aus Siliziumdioxid und kann auch aus gleichen oder verschiedenen Teilschichten bestehen. Sie umgibt die später freizulegende bewegliche Struktur 3, die beispielsweise aus Polysilizium oder einem Metall besteht, vollständig. Die Anordnung weist auch eine obere Schicht 4 auf, aus der eine feste Struktur des mikromechanischen Bauteils gebildet wird und die aus demselben Material wie die bewegliche Struktur bestehen kann.
- FIG 2: Es wird eine Fotomaske 5 aufgebracht, und mit dieser werden die obere Schicht 4 und die Zwischenschicht 2 geätzt. In diesem Beispiel erfolgt die erste Ätzung anisotrop und die zweite isotrop. Es können aber auch andere Ätzprozesse eingesetzt werden. Die Öffnung 6 in der Zwischenschicht muß so dimensioniert sein, daß ein Teil der beweglichen Struktur 3 und ein Teil einer geeigneten Halterung freiliegen. In diesem Fall werden sowohl das Substrat 1 als auch die obere Schicht 4 als Halterung verwendet.
- FIG 3: Die Lackmaske 5 wird entfernt und eine neue Fotolackschicht 7 aufgebracht, die die Öffnung 6 auffüllt und hier die Hilfsstruktur 7a bildet. Die Fotolackschicht 7 dient gleichzeitig als Maske für die Freiätzung der beweglichen Struktur 3.
- FIG 4: Für die Freiätzung muß zunächst die obere Schicht 4 geätzt werden, anschließend wird die Zwischenschicht 2 um die bewegliche Struktur 3 herum mittels eines üblichen isotropen Ätzprozesses vollständig entfernt. Die bewegliche Struktur 3 ist nun über die Hilfsstruktur 7a mit der Halterung, hier also dem Substrat 1 und der oberen Schicht 4, verbunden. Die obere Schicht 4 ist außerhalb der Zeichenebene bspw. über nichtentfernte Teile der Zwischenschicht 2 fest mit dem Substrat verbunden. Anschließend wird die Fotolackschicht 7 einschließlich der Hilfsstruktur 7a mit Hilfe eines O₂-Plasmas oder Ozon entfernt, so daß die bewegliche Struktur vollständig freigelegt wird.

## Patentansprüche

1. Herstellverfahren für ein mikromechanisches Bauteil mit einer beweglichen Struktur auf einem Halbleitersubstrat,
- bei dem die bewegliche Struktur (3), eine Zwischenschicht (2), eine obere Schicht (4) und eine als Halterung (1,4) dienende Schicht oder Struktur derart erzeugt werden, daß die bewegliche Struktur (3) in die Zwischenschicht (2) eingebettet ist und von der Halterung (1,4) durch einen Teil der Zwischenschicht getrennt ist, und daß die obere Schicht (4) auf der Zwischenschicht (2) angeordnet ist,
- bei dem eine Öffnung (6) in der obere Schicht (4) und in der Zwischenschicht (2) erzeugt wird, die die bewegliche Struktur (3) und die Halterung (1, 4) teilweise freilegt,
- bei dem eine Fotolackschicht aufgebracht wird, so daß in der Öffnung (6) eine Hilfsstruktur (7a) erzeugt wird, die die Öffnung auffüllt und die bewegliche Struktur (3) und die Halterung (1, 4) miteinander verbindet,
- bei dem die Fotolackschicht zu einer Maske stukturiert wird, die eine Öffnung zum Freilegen der beweglichen Struktur besitzt, wobei die Hilfsstruktur (7a) unverändert bleibt,
- bei dem in einem Ätzprozeß durch diese Öffnung hindurch die obere Schicht (4) geätzt wird und die Zwischenschicht (2) in der Umgebung der beweglichen Struktur (3) entfernt wird, und
- bei dem danach die Hilfsstruktur (7a) mithilfe eines Trockenätzprozesses entfernt wird.

2. Herstellverfahren nach Anspruch 1,
bei dem als Halterung das Halbleitersubstrat (1) und/oder eine feste Struktur (4) des mikromechanischen Bauteils verwendet wird.

## Claims

1. Method for fabricating a micromechanical component having a moveable structure on a semiconductor substrate,
- in which the moveable structure (3) an intermediate laye: (2), an upper layer (4) and a layer or structure serving as a mount (1, 4) are produced in such a way that the moveable structure (3) is embedded in the intermediate layer (2) and is separated from the mount (1, 4) by part of the intermediate layer, and in that the upper layer (4) is arranged on the intermediate layer (2),
- in which an opening (6) is produced in the upper layer (4) and in the intermediate layer (2), which partially uncovers the moveable structure (3) and the mount (1, 4),
- in which a photoresist layer is applied, with the result that an auxiliary structure (7a) is produced in the opening (6), which auxiliary structure fills the opening and connects the moveable structure (3) and the mount (1, 4) to one another,
- in which the photoresist layer is patterned to form a mask which has an opening for uncovering the moveable structure, the auxiliary structure (7a) remaining unchanged,
- in which, in an etching process, the upper layer (4) is etched through this opening and the intermediate layer (2) is removed in the vicinity of the moveable structure (3), and
- in which the auxiliary structure (7a) is subsequently removed with the aid of a dry etching process.

2. Fabrication method according to Claim 1,
in which the semiconductor substrate (1) and/or a fixed structure (4) of the micromechanical component is used as the mount.

## Revendications

1. Procédé de fabrication pour un élément micromécanique avec une structure mobile sur un substrat semiconducteur.
- dans lequel on réalise la structure mobile (3), une couche intermédiaire (2), une couche supérieure (4) et une couche ou structure servant de support (1, 4) de telle façon que la structure mobile (3) est encastrée dans la couche intermédiaire (2) et est séparée du support (1, 4) par une partie de ladite couche intermédiaire et que la couche supérieure (4) est placée sur la couche intermédiaire (2),
- dans lequel on crée une ouverture (6) dans la couche supérieure (4) et dans la couche intermédiaire (2), qui dégarnit en partie la structure mobile (3) et le support (1, 4),
- dans lequel on dépose une pellicule photosensible, de manière à créer dans l'ouverture (6) une structure auxiliaire (7a) qui remplit ladite ouverture et qui relie entre eux la structure mobile (3) et le support (1, 4),
- dans lequel on structure la pellicule photosensible de manière à obtenir un masque qui possède une ouverture pour dégarnir la structure mobile, la structure auxiliaire (7a) restant inchangée,
- dans lequel, dans un processus de gravure, on grave la couche supérieure (4) à travers cette ouverture et on supprime la couche intermédiaire (2) au voisinage de la structure mobile (3), et
- dans lequel on supprime ensuite la structure auxiliaire (7a) au moyen d'un processus de gravure à sec.

2. Procédé de fabrication selon la revendication 1, dans lequel le substrat semi-conducteur (1) et/ou une structure solide (4) de l'élément micromécanique est utilisé comme support.
